# EUROPÄISCHE PATENTANMELDUNG

(11) **EP 3 273 474 A1**
(43) Veröffentlichungstag der Anmeldung: **24.01.2018**
(21) Anmeldenummer: 17179930.7
(22) Anmeldetag: 06.07.2017
(51) Int. Cl.: H01L 23/433, H01L 23/00, H01L 25/07

(54) **LEISTUNGSELEKTRONISCHE SCHALTEINRICHTUNG, ANORDNUNG HIERMIT UND VERFAHREN ZUR HERSTELLUNG DER SCHALTEINRICHTUNG**

(30) Priorität: 22.07.2016 DE 102016113539
(71) Anmelder: SEMIKRON Elektronik GmbH & Co. KG, 90431 Nürnberg (DE)
(72) Erfinder: Kobolla, Harald, 90556 Seukendorf (DE); Ammon, Jörg, 91052 Erlangen (DE)

(57) **Zusammenfassung**

Es wird eine Schalteinrichtung mit einem Substrat, einem hierauf angeordneten Leistungshalbleiterbauelement, mit einer Verbindungseinrichtung und mit einer Druckeinrichtung vorgestellt, wobei das Substrat gegeneinander elektrisch isolierte Leiterbahnen aufweist und auf einer der Leiterbahnen ein Leistungshalbleiterbauelement mit seiner ersten Hauptfläche angeordnet und elektrisch leitend damit verbunden ist, wobei die Verbindungseinrichtung als Folienverbund mit einer elektrisch leitenden und einer elektrisch isolierenden Folie ausgebildet ist und somit eine erste und eine zweite Hauptfläche ausbildet, wobei die Schalteinrichtung mittels der Verbindungseinrichtung intern schaltungsgerecht verbunden ist und hierbei eine Kontaktfläche der Verbindungseinrichtung mit einer ersten Kontaktfläche einer der Leiterbahnen kraftschlüssig und elektrisch leitend verbunden ist, hierzu die Druckeinrichtung einen Druckkörper und ein hiervon in Richtung des Substrats hervorstehendes Druckelement aufweist, wobei das Druckelement auf einen ersten Abschnitt der zweiten Hauptfläche des Folienverbunds drückt und hierbei das Druckelement, dieser erste Abschnitt und die erste Kontaktfläche der Leiterbahn in Normalenrichtung des Substrats zueinander fluchtend angeordnet sind.

## Beschreibung

Die Erfindung beschreibt eine leistungselektronische Schalteinrichtung, die eine Basiszelle eines Leistungshalbleitermoduls oder eines leistungselektronischen Systems ausbilden kann, indem sie alleine oder in Kombination mit weiteren, vorzugsweise identischen, Basiszellen den leistungselektronischen Grundbaustein des Leistungshalbleitermoduls oder des leistungselektronischen Systems bildet. Weiterhin beschreibt die Erfindung eine Anordnung mit einer derartigen leistungselektronischen Schalteinrichtung, sowie ein Herstellungsverfahren einer besonders bevorzugten Ausführungsform einer derartigen leistungselektronischen Schalteinrichtung.

Aus dem Stand der Technik, beispielhaft offenbart in der DE 10 2013 104 949 B3, ist eine Schalteinrichtung mit einem Substrat, einem Leistungshalbleiterbauelement, einer Verbindungseinrichtung, Lastanschlusseinrichtungen und einer Druckeinrichtung bekannt. Hierbei weist das Substrat elektrisch isolierte Leiterbahnen auf, wobei auf einer Leiterbahn ein Leistungshalbleiterbauelement angeordnet ist. Die Verbindungseinrichtung ist als Folienverbund mit einer elektrisch leitenden und einer elektrisch isolierenden Folie ausgebildet und weist eine erste und eine zweite Hauptfläche auf. Hiermit wird die Schalteinrichtung intern schaltungsgerecht verbunden. Die Druckeinrichtung weist einen Druckkörper mit einer ersten Ausnehmung auf, aus der ein Druckelement hervorstehend angeordnet ist, wobei das Druckelement auf einen Abschnitt der zweiten Hauptfläche des Folienverbunds drückt und hierbei dieser Abschnitt in Projektion entlang der Normalenrichtung des Leistungshalbleiterbauelements innerhalb der Fläche des Leistungshalbleiterbauelements angeordnet ist.

In Kenntnis der genannten Gegebenheiten liegt der Erfindung die Aufgabe zugrunde, eine leistungselektronische Schalteinrichtung und eine Anordnung hiermit, sowie ein Verfahren zur Herstellung der Schalteinrichtung vorzustellen, wobei die Schalteinrichtung bezüglich ihrer Komplexität und ihres Herstellungsaufwands optimiert ist.

Diese Aufgabe wird erfindungsgemäß gelöst durch eine leistungselektronische Schalteinrichtung mit den Merkmalen des Anspruchs 1, durch eine Anordnung mit einer leistungselektronischen Schalteinrichtung mit den Merkmalen des Anspruchs 8 sowie durch zwei spezielle Herstellungsverfahren mit den Merkmalen der Ansprüche 11 bzw. 13. Bevorzugte Ausführungsformen sind in abhängigen Ansprüchen beschrieben.

Die erfindungsgemäße leistungselektronische Schalteinrichtung ist ausgebildet mit einem Substrat, einem hierauf angeordneten Leistungshalbleiterbauelement, mit einer Verbindungseinrichtung und mit einer Druckeinrichtung, wobei das Substrat gegeneinander elektrisch isolierte Leiterbahnen aufweist und auf einer der Leiterbahnen ein Leistungshalbleiterbauelement mit seiner ersten Hauptfläche angeordnet und elektrisch leitend damit verbunden ist, wobei die Verbindungseinrichtung als Folienverbund mit einer elektrisch leitenden und einer elektrisch isolierenden Folie ausgebildet ist und somit eine erste und eine zweite Hauptfläche ausbildet, wobei die Schalteinrichtung mittels der Verbindungseinrichtung intern schaltungsgerecht verbunden ist und hierbei eine Kontaktfläche der Verbindungseinrichtung mit einer ersten Kontaktfläche einer der Leiterbahnen kraftschlüssig und elektrisch leitend verbunden ist, hierzu die Druckeinrichtung einen Druckkörper und ein hiervon in Richtung des Substrats hervorstehendes Druckelement aufweist, wobei das Druckelement auf einen ersten Abschnitt der zweiten Hauptfläche des Folienverbunds drückt und hierbei das Druckelement, dieser erste Abschnitt und die erste Kontaktfläche der Leiterbahn in Normalenrichtung des Substrats zueinander fluchtend angeordnet sind.

Es wird bei dieser Schalteinrichtung also explizit auf eine stoffschlüssige Verbindung der Kontaktfläche der Verbindungseinrichtung mit der zugeordneten Kontaktfläche des Substrats, genauer eine Leiterbahn, verzichtet. Hierdurch wird gegenüber dem Stand der Technik eine, bevorzugt als Drucksinterverbindung ausgebildete, stoffschlüssige Verbindung durch eine kraftschlüssige ersetzt. Es wird hierbei bewusst in Kauf genommen, dass ein elektrischer Funktionstest der Schaltungsanordnung nur mit einer Druckbeaufschlagung im Sinne einer weiter unten beschriebenen Anordnung möglich ist.

Bevorzugt ist es, wenn eine zweite Kontaktfläche der Verbindungseinrichtung kraft- oder stoffschlüssig und elektrisch leitend mit einer Kontaktfläche der zweiten Hauptfläche des Leistungshalbleiterbauelements verbunden ist.

Ebenso kann das Leistungshalbleiterbauelement mit einer Kontaktfläche seiner ersten Hauptfläche kraft- oder stoffschlüssig mit der zugeordneten Leiterbahn elektrisch leitend verbunden sein.

Bevorzugt ist es hierbei, wenn die jeweilige stoffschlüssige Verbindung als fachübliche Löt-, Klebe- oder insbesondere Drucksinterverbindung ausgebildet ist.

Besonders bevorzugt ist es, wenn der Druckkörper eine erste Ausnehmung aufweist, aus der das Druckelement hervorsteht. Hierbei ist es weiterhin vorteilhaft, wenn diese erste Ausnehmung des Druckkörpers als Vertiefung ausgehend von einer ersten Hauptfläche ausgebildet ist, das Druckelement hierbei diese Ausnehmung des Druckkörpers vollständig oder annähernd vollständig ausfüllt und das Druckelement aus der Ausnehmung des Druckkörpers an dessen erster Hauptfläche in Richtung auf die Verbindungseinrichtung, genauer deren zweite Hauptfläche, hervorsteht.

Erfindungsgemäß ausgebildet ist die Anordnung mit einer vorbeschriebenen elektronischen Schalteinrichtung, mit einer Kühleinrichtung und mit einer Druckeinleiteinrichtung, wobei diese Druckeinleiteinrichtung sich mittelbar oder unmittelbar gegen die Kühleinrichtung abstützt, vorzugsweise mittig auf die Druckeinrichtung Druck einleitet und hierdurch die Schalteinrichtung kraftschlüssig mit der Kühleinrichtung verbunden ist.

Ebenso ist es auf Grund der besonders wirksamen Druckeinleitung möglich, dass zwischen dem Substrat und der Kühleinrichtung eine wärmeleitende Schicht, insbesondere ein Wärmeleitpaste, mit einer Dicke von weniger als 20µm, insbesondere von weniger als 10µm, insbesondere von weniger als 5µm angeordnet werden kann.

Ebenso kann es bevorzugt sein, wenn die Kühleinrichtung eine vorzugsweise metallische Grundplatte eines Leistungshalbleitermoduls oder ein Kühlkörper ist.

Das erfindungsgemäße Verfahren zur Herstellung einer ersten besonders bevorzugten Ausgestaltung einer o.g. leistungselektronischen Schalteinrichtung weist die folgenden, vorzugsweise in dieser Reihenfolge anzuwendenden, Schritte auf:
A. Bereitstellen des Substrats mit einer Isolationslage und mit gegeneinander elektrisch isolierten Leiterbahnen, wobei auf einer der Leiterbahnen ein Leistungshalbleiterbauelement angeordnet und stoffschlüssig mit dieser Leiterbahn verbunden ist;
B. Bereitstellen der Verbindungseinrichtung ausgebildet als Folienstapel alternierend ausgebildet mit zwei elektrisch leitenden, in sich strukturierten Folien und einer elektrisch isolierenden Folie zwischen den beiden leitenden Folien;
C. Anordnen eines adhäsiven Stoffs auf dem Substrat oder der Verbindungseinrichtung an Klebeabschnitten, die nicht der elektrisch leitenden Verbindung zwischen diesen beiden Verbindungspartnern, also der Verbindungseinrichtung und dem Substrat, dienen;
D. Anordnen und haftendes Verbinden der Verbindungseinrichtung mit dem Substrat mittels des adhäsiven Stoffs;
E. Druckeinleitung mittels einer Druckeinrichtung und einer Druckeinleiteinrichtung auf die Verbindungseinrichtung derart, dass zwischen der Verbindungseinrichtung und der zugeordneten Leiterbahn eine kraftschlüssige, elektrisch leitende Verbindung ausgebildet wird.

Vorteilhafterweise wird zusätzlich auch zwischen der Verbindungseinrichtung und dem Leistungshalbleiterbauelement eine kraftschlüssige elektrisch leitende Verbindung ausgebildet.

Das erfindungsgemäße Verfahren zur Herstellung einer zweiten besonders bevorzugten Ausgestaltung einer o.g. leistungselektronischen Schalteinrichtung weist die folgenden, vorzugsweise in dieser Reihenfolge anzuwendenden, Schritte auf:
a. Bereitstellen des Substrats mit einer Isolationslage und mit gegeneinander elektrisch isolierten Leiterbahnen;
b. Bereitstellen der Verbindungseinrichtung ausgebildet als Folienstapel alternierend ausgebildet mit zwei elektrisch leitenden, in sich strukturierten Folien und einer elektrisch isolierenden Folie zwischen den beiden leitenden Folien;
c. Anordnen des Leistungshalbleiterbauelements auf einer zugeordneten Leiterbahn;
d. Anordnen eines adhäsiven Stoffs zu dem Leistungshalbleiterbauelement und zu einer zugeordneten Leiterbahn zur haftenden Fixierung des Leistungshalbleiterbauelements auf dieser Leiterbahn;
e. Anordnen und haftendes Verbinden der Verbindungseinrichtung mit dem Substrat mittels des adhäsiven Stoffs;
f. Druckeinleitung mittels einer Druckeinrichtung und einer Druckeinleiteinrichtung auf die Verbindungseinrichtung derart, dass zwischen dem Leistungshalbleiterbauelement und der zugeordneten Leiterbahn des Substrats eine kraftschlüssige, elektrisch leitende Verbindung ausgebildet wird.

Vorteilhafterweise wird zusätzlich sowohl zwischen der Verbindungseinrichtung und dem Leistungshalbleiterbauelement, wie auch zwischen dem Leistungshalbleiterbauelement und der zugeordneten Leiterbahn eine kraftschlüssige elektrisch leitende Verbindung ausgebildet.

Selbstverständlich können, sofern dies nicht per se ausgeschlossen ist, die im Singular genannten Merkmale, insbesondere das Leistungshalbleiterbauelement, mehrfach in der jeweiligen leistungselektronischen Schalteinrichtung oder der Anordnung hiermit vorhanden sein.

Es versteht sich, dass die verschiedenen Ausgestaltungen der Erfindung einzeln oder in beliebigen Kombinationen realisiert sein können, um Verbesserungen zu erreichen. Insbesondere sind die vorstehend und im Folgenden genannten und erläuterten Merkmale, unabhängig ob sie im Rahmen der leistungselektronischen Schalteinrichtung, der Anordnung oder einem der Verfahren genannt sind, nicht nur in den angegebenen Kombinationen, sondern auch in anderen Kombinationen oder in Alleinstellung einsetzbar, ohne den Rahmen der vorliegenden Erfindung zu verlassen.

Weitere Erläuterung der Erfindung, vorteilhafte Einzelheiten und Merkmale, ergeben sich aus der nachfolgenden Beschreibung der in den Fig. 1 bis 6 dargestellten Ausführungsbeispiele.
Figur 1 zeigt in Explosionsdarstellung eine erfindungsgemäße Anordnung mit einer erfindungsgemäßen leistungselektronischen Schalteinrichtung.
Figur 2 bis 5 zeigen verschiedene Ausgestaltungen erfindungsgemäßer leistungselektronischer Schalteinrichtungen.
Figur 6 zeigt eine Draufsicht auf eine leistungselektronische Schalteinrichtung in verschiedenen Schnittebenen.

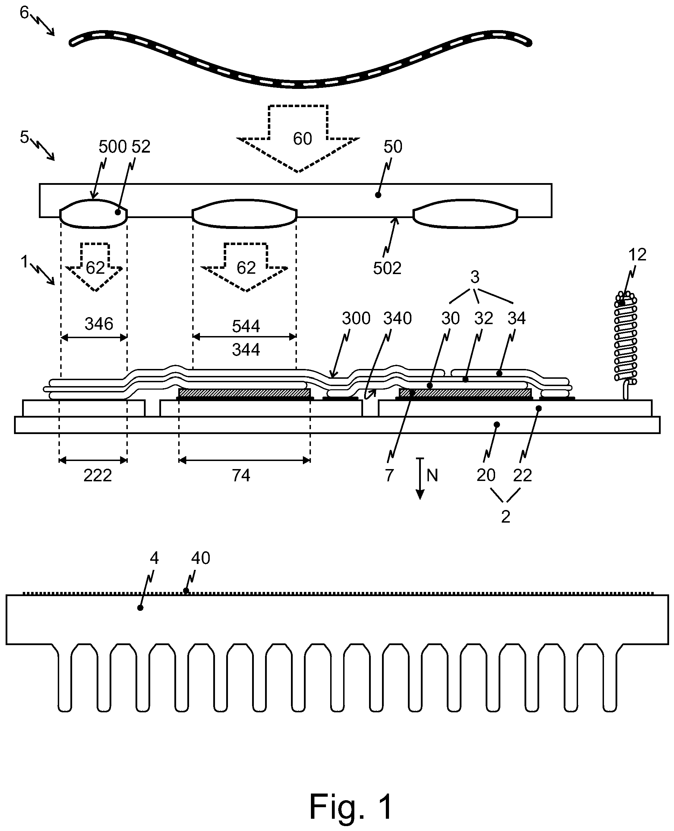

Figur 1 zeigt in schematischer Explosionsdarstellung eine erste Ausgestaltung einer erfindungsgemäßen leistungselektronischen Schalteinrichtung 1. Dargestellt ist ein grundsätzlich fachüblich ausgebildetes Substrat 2 mit einem Isolierstoffkörper 20 und hierauf angeordneten, jeweils elektrisch voneinander isolierten, Leiterbahnen 22, die unterschiedliche Potentiale, insbesondere Lastpotentiale, aber auch Hilfs-, insbesondere Schalt- und Messpotentiale, der Schalteinrichtung aufweisen. Konkret dargestellt sind hier drei Leiterbahnen 22 mit Lastpotentialen wie sie für eine Halbbrückentopologie typisch sind.

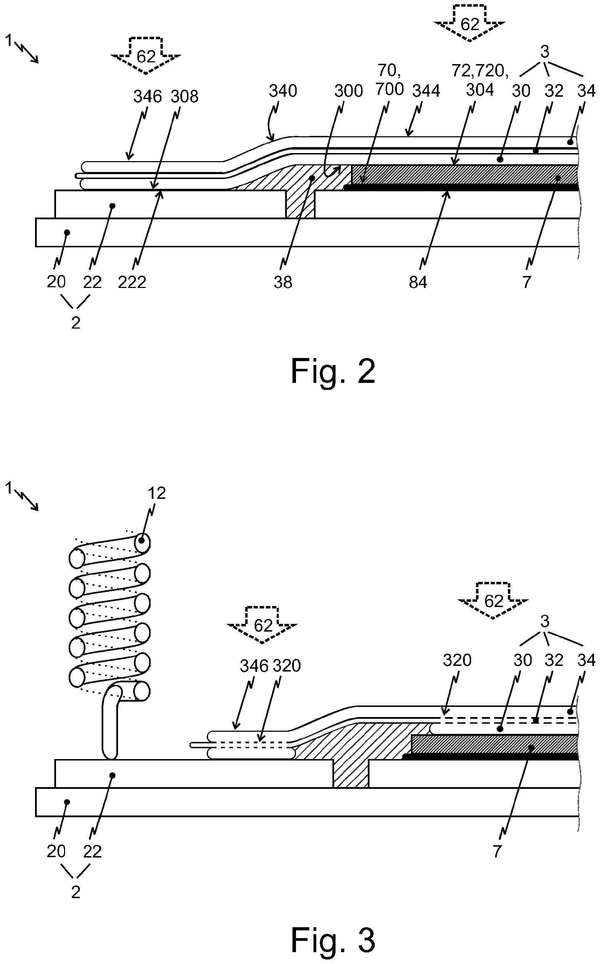

Auf zwei Leiterbahnen 22 ist jeweils ein Leistungshalbleiterbauelement 7 angeordnet, der fachüblich als Einzelschalter, beispielhaft als MOS-FET, oder als IGBT mit antiparallel geschalteter Leistungsdiode, die hier dargestellt ist, ausgebildet sein kann. Die Leistungshalbleiterbauelemente 7, genauer deren erste Kontaktfläche (700, vgl. Figur 2) der ersten Hauptfläche (70, vgl. Figur 2) sind fachüblich, bevorzugt mittels einer Drucksinterverbindung 84, stoffschlüssig mit den Leiterbahnen 22 elektrisch leitend verbunden.

Die internen Verbindungen der Schalteinrichtung 1 sind ausgebildet mittels einer Verbindungseinrichtung 3 aus einem Folienverbund, der alternierend elektrisch leitende Folien 30, 34 und elektrisch isolierende Folien 32 aufweist. Hier weist der Folienverbund genau zwei leitende und eine dazwischen angeordnete isolierende Folie auf. Die dem Substrat 2 zugewandte Oberfläche dieses Folienverbunds 3 bildet hierbei dessen erste Hauptfläche 300 aus, während die gegenüberliegende dessen zweite Hauptfläche 340 ausbildet. Insbesondere die leitenden Folien 30, 34 der Verbindungseinrichtung 3 sind in sich strukturiert und bilden somit voneinander elektrisch isolierte Leiterbahnabschnitte aus. Diese Leiterbahnabschnitte verbinden insbesondere das jeweilige Leistungshalbleiterbauelement 7, genauer dessen Kontaktflächen auf der dem Substrat 2 abgewandten Seite, mit Leiterbahnen 22 des Substrats.

Zur externen elektrischen Anbindung weist die leistungselektronische Schalteinrichtung 1 Last- und Hilfsanschlusselemente auf, wobei hier nur ein Lastanschlusselement dargestellt ist. Dieses Lastanschlusselement ist ohne Beschränkung der Allgemeinheit hier als Kontaktfeder 12 ausgebildet. Grundsätzlich können auch Teile der Verbindungseinrichtung 3 selbst als Last- oder Hilfsanschlusselemente ausgebildet sein. Die nicht dargestellten Hilfsanschlusselemente, wie Gate- oder Sensoranschlüsse, sind vorzugsweise ebenfalls fachüblich ausgebildet.

Die fachübliche Druckeinrichtung 5 weist eine erste 502 dem Substrat 2 zugewandte und eine zweite dem Substrat 2 abgewandte Hauptfläche auf und ist hier der Übersicht halber beabstandet von der Verbindungseinrichtung 3 dargestellt. Die Druckeinrichtung 5 besteht aus einem Druckkörper 50 und einer Mehrzahl, dargestellt sind drei, Druckelementen 52. Der Druckkörper 50 ist besonders starr ausgebildet, um auf ihn eingeleiteten Druck homogen auf die Druckelemente 52 weitergeben zu können. Die Druckelementen 52 sind in Ausnehmung 500 des Druckkörpers 50, die als Vertiefung ausgehend von einer ersten Hauptfläche 502 ausgebildet sind, angeordnet. Sie füllen diese Ausnehmungen 500 vollständig aus stehen aus ihnen an der erster Hauptfläche 502 in Richtung auf das Substrat 2 hervor Hierzu und vor dem Hintergrund der thermischen Belastungen beim Betrieb der Schalteinrichtung besteht der Druckkörper 50 aus einem hochtemperaturbeständigen thermoplastischen Kunststoff, insbesondere aus Polyphenylensulfid. Die Druckelemente 52 müssen im Betrieb und hierbei insbesondere bei unterschiedlichen Temperarturen, einen im Wesentlichen konstanten Druck ausüben können. Hierzu bestehen die Druckelemente 52 aus einem Elastomer, bevorzugt aus einem Silikonelastomer, besonders bevorzugt aus sog. vernetztem Flüssig-Silikon (LSR - Liquid Silicone Rubber).

Die Anordnung weist weiterhin einen Kühlkörper 4 auf, dessen Oberfläche mit einer wärmeleitenden Schicht 40 bedeckt ist auf der die leistungselektronische Schalteinrichtung 1, genauer deren Substrat 2, angeordnet ist. Die wärmeleitende Schicht 40 kann aufgrund der erfindungsgemäßen Ausgestaltung der Anordnung eine sehr geringe Dicke aufweisen, die hier zwischen 5µm und 10µm beträgt. Grundsätzlich könnte auf die wärmeleitende Schicht vollständig verzichtet werden. Dies ist abhängig von der Oberflächenbeschaffenheit, insbesondere der Rauigkeit des Kühlkörpers 4.

Alternativ kann die Isolationslage 20 des Substrats 2 als eine elektrisch isolierende Folie ausgebildet sein, die unmittelbar auf den Kühlkörper 4 laminiert ist. Auch in diesem Fall können die Leiterbahnen 22 als flächige Leitungselemente aus Kupfer ausgebildet sein. Vorteilhafterweise weist diese dann eine Dicke von 0,5mm bis 1,0mm auf.

Die Anordnung weist weiterhin eine Druckeinleiteinrichtung 6 auf, die oberhalb der Verbindungseinrichtung 3 angeordnet ist. Mittels dieser Druckeinleiteinrichtung 6, die sich, nicht dargestellt, gegen den Kühlkörper abstützt, wird Druck 60 auf den Druckkörper 50 eingeleitet. Dieser Druck 60 wird jeweils als Teildruck 62 mittels der Druckelemente 52 unmittelbar auf einen ersten Abschnitt 346 und einen zweiten Abschnitt 344 der zweiten Hauptfläche 340 des Folienverbunds 3 übertragen. Der zweite Abschnitt 344 drückt nun mittelbar, unter Ausbildung der kraftschlüssigen Verbindung eine Kontaktfläche (304, vgl. Figur 2) der ersten Hauptfläche 300 des Folienverbunds 3 auf eine zugeordnete Kontaktfläche (720, vgl. Figur 2) der zweiten Hauptfläche 72 des Leistungshalbleiterbauelements 7. Dieser zweite Abschnitt 344 ist in Projektion entlang der Normalenrichtung N des Substrats 2 innerhalb der Fläche 74 des Leistungshalbleiterbauelements 7 angeordnet. Der erste Abschnitt 346 drückt mittelbar, unter Ausbildung der kraftschlüssigen Verbindung eine Kontaktfläche 308 der ersten Hauptfläche 300 des Folienverbunds 3 auf eine Kontaktfläche 222 der zugeordneten Leiterbahn 22 des Substrats 2.

Der eingeleitete Druck 60 drückt weiterhin das gesamte Substrat 2 auf den Kühlkörper 4. Die Druckkontakte, die derjenigen elektrisch leitenden zwischen der Verbindungseinrichtung 3 und dem Leistungshalbleiterbauelement 7 bzw. der Verbindungseinrichtung 3 und dem Substrat 2, wie auch der thermisch leitenden zwischen dem Substrat 2 und dem Kühlkörper 4 erfolgt jeweils in Normalenrichtung N des Substrats 2, bzw. des Substrats 2. Somit wird einerseits eine hoch effiziente, mit äußerst geringem Übergangswiderstand behaftetet, kraftschlüssige und elektrisch leitende Verbindung zwischen der Verbindungseinrichtung 3 und dem Leistungshalbleiterbauelement 7 und auch zwischen der Verbindungseinrichtung 3 und der zugeordneten Leiterbahn 22 ausgebildet. Andererseits wird gleichzeitig eine ebenso effiziente thermisch leitende Verbindung zwischen dem Substrat 2 und dem Kühlkörper 4 ausgebildet, die genau an derjenigen Stelle mit der höchsten Wärmeentwicklung, also dem Leistungshalbleiterbauelement 7, ihre wirksamste Wärmeübertragung ausbildet.

Figur 2 zeigt eine Schnittansicht einer ersten Ausgestaltung einer erfindungsgemäßen, leistungselektronischen Schalteinrichtung 1, wie sie im Grunde bereits in Figur 1 dargestellt ist.

Dargestellt ist hier das Substrat 2, mit einer Isolierlage 20 und zwei Leiterbahnen 22. Auf der rechten Leiterbahn ist ein Leistungshalbleiterbauelement 7, ausgebildet als eine Leistungsdiode, angeordnet und elektrisch leitend mittels einer stoffschlüssigen Verbindung, hier einer Drucksinterverbindung 84, mit der Leiterbahn 22 verbunden.

Die Verbindungseinrichtung 3 weist eine erste elektrisch leitende Folie 30 auf, deren Kontaktfläche 304 mit der korrespondierenden Kontaktfläche 720 des Leistungshalbleiterbauelements 7 kraftschlüssigen verbunden ist.

Die Ausbildung dieser kraftschlüssigen Verbindung erfolgt indem ein Teildruck 62, vgl. Figur 1, unmittelbar auf einen zweiten Abschnitt 344 der zweiten Hauptfläche 340 der Verbindungseinrichtung, hier des Folienverbunds 3, eingeleitet wird. Die jeweiligen Kontaktstellen 304, 720 der kraftschlüssigen Verbindung sind hier in bevorzugter Weise mit einer Goldoberfläche, insbesondere einer wenige Mikrometer dünnen Goldschicht, versehen, da diese beste Kontakteigenschaften und Übergangswiderstände aufweisen. Zudem weisen die jeweiligen Kontaktstellen 304, 720 der kraftschlüssigen Verbindung eine Rautiefe (Rz) von weniger als 5µm, insbesondere von weniger als 2µm, und einen Mittenrauwert (Ra) von weniger als 1µm, insbesondere von weniger als 0,5µm, jeweils bestimmt gemäß EN ISO 4287, auf.

Die zweite Kontraktliche 720 des Leistungshalbleiterbauelements 7 ist elektrisch leitend mit der linken Leiterbahn 22 verbunden. Hierzu reicht die erste Metallfolie 30 des Folienverbunds 3 von der Kontaktstelle 304 mit dem Leistungshalbleiterbauelement 7 bis zu einer Kontaktstelle 222 der linken Leiterbahn 22. Die dortige Verbindung zwischen der Kontaktstelle 222 der Leiterbahn 22 des Substrats und der Kontaktstelle 308 der ersten leitenden Folie 30 des Folienverbunds 3 ist kraftschlüssige ausgebildet. Diese erfolgt indem ein Teildruck 62, vgl. Figur 1, unmittelbar auf einen ersten Abschnitt 348 der zweiten Hauptfläche 340 der Verbindungseinrichtung, hier des Folienverbunds 3, eingeleitet wird. Die Beschaffenheit der jeweiligen Kontaktstellen 222, 308 ist bevorzugt analog den oben bei dieser Figur beschriebenen Kontaktstellen ausgebildet.

Die Verbindungseinrichtung 3 weist weiterhin eine elektrisch isolierende 32 und eine weitere elektrisch leitende Folie 34 auf, die zusammenwirkend die weitere schaltungsgereichte interne Verbindung der leistungselektronischen Schalteinrichtung 1 ausbilden.

Zudem weist die leistungselektronische Schalteinrichtung 1 einen, bevorzugt gelartigen, Isolierstoff 38 auf, der im Zwischenraum zwischen Substrat 2, Verbindungseinrichtung 3 und Leistungshalbleiterbauelement 7 angeordnet ist. Dieser dient der inneren elektrischen Isolation insbesondere derjenigen zwischen der ersten leitenden Folie 30 der Verbindungseinrichtung 3 zur rechten Leiterbahn 22 des Substrats 2.

Figur 3 zeigt eine Schnittansicht einer zweiten Ausgestaltung einer erfindungsgemäßen leistungselektronischen Schalteinrichtung 1. Die elektrisch leitende Verbindung zwischen dem Leistungshalbleiterbauelement 7 und der Verbindungseinrichtung 3 ist hier wiederum mittels der oben beschriebenen kraftschlüssigen Verbindung ausgebildet. Die stoffschlüssige Verbindung des Leistungshalbleiterbauelements 7 mit der ihm zugeordneten, rechten Leiterbahn 22 des Substrats 2 ist ebenfalls wie oben beschrieben ausgebildet. Die kraftschlüssige Verbindung der Verbindungseinrichtung 3 mit der ihr zugeordneten, linken Leiterbahn 22 des Substrats ist ebenfalls wie oben beschrieben ausgebildet.

Im Unterschied zur ersten Ausgestaltung gemäß Figur 2 weist hier die Verbindungseinrichtung 3 in den Kontaktbereichen zum Leistungshalbleiterbauelement 7 wie auch zur linken Leiterbahn nur Abschnitte der ersten elektrisch leitenden Folie 30 auf, die nicht unmittelbar miteinander verbunden sind. Vielmehr sind in diesen Abschnitten Durchkontaktierungen 320 von der ersten 30 zur zweiten leitenden Folie 34 durch die isolierende Folie 32 hindurch angeordnet. Somit erfolgt die elektrische Verbindung zwischen der linken Leiterplatte 22 und dem Leistungshalbleiterbauelement 7 über die zweite elektrisch leitende Folie 34. Auf der linken Leiterbahn 22 ist zudem ein Anschlusselement 12, hier exemplarisch als Federkontaktelement ausgebildet, dargestellt.

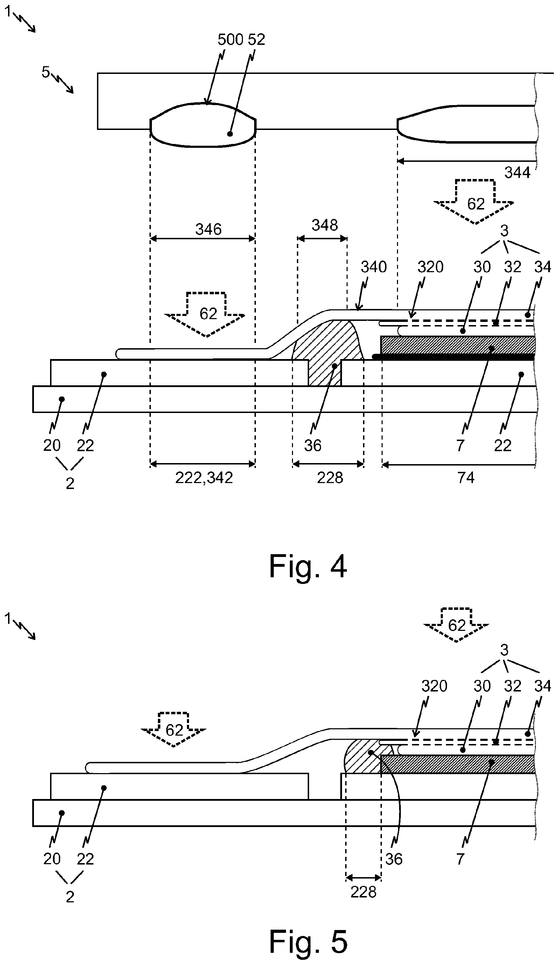

Figur 4 zeigt eine Schnittansicht einer dritten, gemäß dem ersten erfindungsgemäßen Verfahren hergestellten, Ausgestaltung einer erfindungsgemäßen leistungselektronischen Schalteinrichtung 1. Das Substrat 2 mit dem Leistungshalbleiterbauelement 7 ist hier, wie bereits bei Figur 3 beschrieben, ausgebildet.

Auf dem Substrat 2 ist zwischen den beiden Leiterbahnen 22 und diese in Randbereichen überlappend ein elektrisch isolierender adhäsiver Stoff 36, vorzugsweise ein Klebstoff auf Basis von Silikonkautschuk, angeordnet. Dieser sorgt ohne eine Druckbeaufschlagung mittels der Druckeinrichtung 5 für eine adhäsive, also zumindest haftende, Verbindung zwischen dem Substrat 2 in dessen Abschnitt 228 und der Verbindungseinrichtung 3 in deren Abschnitt 348. Wesentlich ist hier, dass diese haftende Verbindung nicht zur elektrischen Leitung beiträgt und somit auch nur in Abschnitten 228,348 angeordnet ist, bei denen kein elektrisch leitender Kontakt zwischen der Verbindungseinrichtung 3 und dem Substrat 2, genauer einer Leiterbahn 22 oder dem Leistungshalbleiterbauelement 7, ausgebildet ist.

Die elektrisch leitende Verbindung zwischen dem Leistungshalbleiterbauelement 7 und der linken Leiterbahn 22 mittels der Verbindungseinrichtung 3 ist hier nicht durch die erste sondern die zweite elektrisch leitende Folie 34 ausgebildet. Hierbei ist im Gegensatz zur Ausgestaltung gemäß Figur 3 im Bereich der linken Leiterbahn 22 kein Abschnitt der ersten leitenden Folie 30 und somit auch keine Durchkontaktierung notwendig. Im Bereich des Leistungshalbleiterbauelements 7 ist die Ausgestaltung der Verbindungseinrichtung 3 wie unter Figur 3 beschrieben.

Die elektrisch leitende Verbindung zwischen der Verbindungseinrichtung 3 und dem Leistungshalbleiterbauelement 7 sowie zwischen der Verbindungseinrichtung 3 und der zugeordneten, linken Leiterbahn 22 des Substrats 2 ist jeweils als kraftschlüssige Verbindung ausgebildet. Hierzu wird jeweils ein Teildruck 62 (vgl. auch Figur 1) mittels jeweils einem zugeordneten Druckelement 52 der Druckeinrichtung 5 auf die jeweilige Verbindung eingeleitet. Hierbei wird also auf einen ersten Abschnitt 346 der zweiten Hauptfläche 340 der Verbindungseinrichtung ein Teildruck 62 ausgeübt, wodurch eine Kontaktfläche 342 der zweiten elektrisch leitenden Folie 34 auf eine Kontaktfläche 222 der linken Leiterbahn 22 gedrückt und damit kraftschlüssig elektrisch leitend verbunden wird.

Ein wesentlicher Vorteil dieser dritten Ausgestaltung der leistungselektronischen Schalteinrichtung 1 ist, dass hier eine stoffschlüssige und elektrisch leitende Verbindung ausschließlich auf Substratebene, also zwischen dem Leistungshalbleiterbauelement 7 und der zugeordneten, rechten Leiterbahn 22 ausgebildet werden muss. Derartige Verbindungen sind fachüblich und auch im Fall von Drucksinterverbindungen relativ einfach herzustellen. Die Verbindungseinrichtung 3 wird dann nur noch haftend verbunden, was ebenfalls einfach auszuführen ist und eine ausreichende Fixierung der Verbindungspartner, also des Substrats 2 und der Verbindungseinrichtung 3 ermöglicht. Erst im Betrieb der leistungselektronischen Schalteinrichtung erfolgt die beschriebene Druckbeaufschlagung, die hier den kraftschlüssigen elektrisch leitenden Kontakt zwischen der Verbindungeinrichtung 3 und dem Leistungshalbleiterbauelement 7 sowie zwischen der Verbindungeinrichtung 3 und der Leiterbahn 22 des Substrats 2 ausbilden.

Figur 5 zeigt eine Schnittansicht einer vierten, gemäß dem zweiten erfindungsgemäßen Verfahren hergestellten, Ausgestaltung einer erfindungsgemäßen leistungselektronischen Schalteinrichtung 1. Im Unterschied zur Figur 4 ist hier auch die Verbindung zwischen dem Leistungshalbleiterbauelement 7 und der zugeordneten Leiterbahn 22 des Substrats 2 kraftschlüssig ausgebildet. Hierzu ist auch das Leistungshalbleiterbauelement 7 mittels des adhäsiven Stoffs 36 zu der zugeordneten Leiterbahn 22 fixiert.

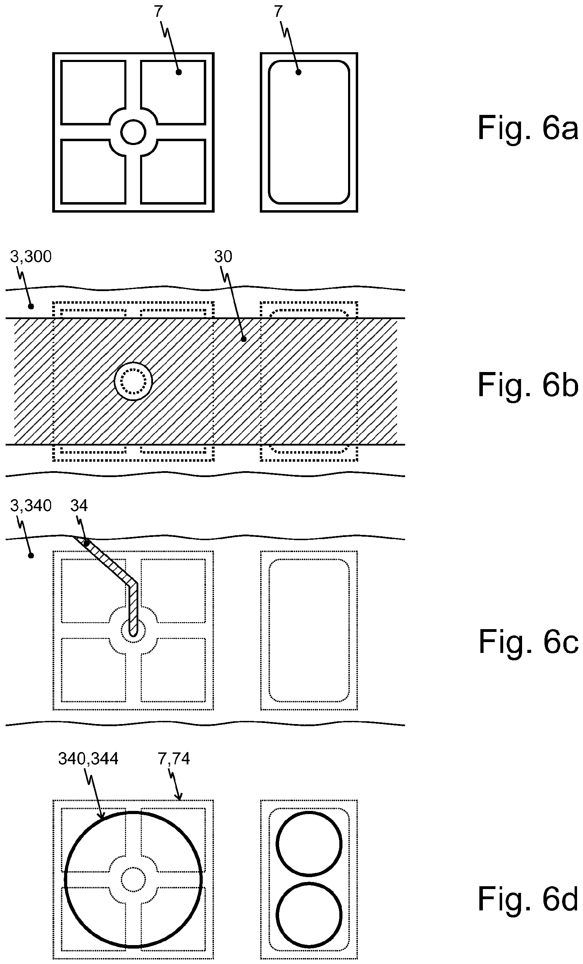

Figur 6 zeigt eine Draufsicht auf eine leistungselektronische Schalteinrichtung 1 in verschiedenen Schnittebenen. Die Schnittebene gemäß Fig. 6a zeigt zwei Leistungshalbleiterbauelemente 7, die typisch aber nicht dargestellt auf einer gemeinsamen Leiterbahn eines Substrats angeordnet sind. Es handelt sich hier ohne Beschränkung der Allgemeinheit um einen Transistor mit einer mittigen Gateanschlussfläche und diese umrahmenden Emitteranschlussflächen und um eine Diode mit einer Kathodenanschlussfläche.

Fig. 6b zeigt die erste, in sich strukturierte, elektrisch leitende Folie 30 der Verbindungseinrichtung 3. Diese bildet eine elektrisch leitende Verbindung zwischen den Emitteranschlussflächen des Transistors und der Kathodenanschlussfläche der Diode aus. Hierbei wird die Gateanschlussfläche des Transistors ausgespart.

Fig. 6c zeigt die zweite in sich strukturierte elektrisch leitende Folie 34 der Verbindungseinrichtung 3. Diese bildet eine elektrisch leitende Verbindung zur Gateanschlussfläche des Transistors.

Fig. 6d zeigt quasi den Fußabdruck der den Leistungshalbleiterbauelementen 7 zugeordneten Kontaktelementen der Kontakteinrichtung, wobei dem Transistor aufgrund seiner quadratischen Grundform nur ein Kontaktelement und der Diode aufgrund ihrer rechteckigen Grundform zwei Kontaktelemente zugeordnet sind. Der jeweilige Fußabdruck entspricht denjenigen zweiten Abschnitten 344 auf der zweiten Hauptfläche 340 der Verbindungseinrichtung 3, die in Normalenrichtung fluchtend zu den Leistungshalbleiterbauelementen angeordnet sind und hierbei auf das jeweilige Leistungshalbleiterbauelement projiziert sind. Hierbei wird ersichtlich, dass die Fläche des Fußabdrucks, also diejenige Fläche die zur Druckeinleitung bestimmt ist, einen möglichst großen Teil der Fläche des Leistungshalbleiterbauelement abdeckt, ohne über diese hinauszugehen.

## Patentansprüche

1. Leistungselektronische Schalteinrichtung (1) mit einem Substrat (2), einem hierauf angeordneten Leistungshalbleiterbauelement (7), mit einer Verbindungseinrichtung (3) und mit einer Druckeinrichtung (5),
wobei das Substrat (2) gegeneinander elektrisch isolierte Leiterbahnen (22) aufweist und auf einer der Leiterbahnen (22) ein Leistungshalbleiterbauelement (7) mit seiner ersten Hauptfläche (70) angeordnet und elektrische leitend damit verbunden ist,
wobei die Verbindungseinrichtung (3) als Folienverbund mit einer elektrisch leitenden (30, 34) und einer elektrisch isolierenden Folie (32) ausgebildet ist und somit eine erste und eine zweite Hauptfläche (300, 340) ausbildet, wobei die Schalteinrichtung mittels der Verbindungseinrichtung (3) intern schaltungsgerecht verbunden ist und hierbei eine Kontaktfläche (308, 342) der Verbindungseinrichtung (3) mit einer ersten Kontaktfläche (222) einer der Leiterbahnen (22) kraftschlüssig und elektrisch leitend verbunden ist, hierzu die Druckeinrichtung (5) einen Druckkörper (50) und ein hiervon in Richtung des Leistungshalbleiterbauelements (7) hervorstehendes Druckelement (52) aufweist, wobei das Druckelement (52) auf einen ersten Abschnitt (346) der zweiten Hauptfläche (340) des Folienverbunds (3) drückt und hierbei das Druckelement, dieser erste Abschnitt (346) und die ersten Kontaktfläche (222) der Leiterbahn (22) in Normalenrichtung (N) des Substrats 2 zueinander fluchtend angeordnet sind.

2. Schalteinrichtung nach Anspruch 1, wobei
eine zweite Kontaktfläche (304) der Verbindungseinrichtung kraft- oder stoffschlüssig und elektrisch leitend mit einer Kontaktfläche (720) der zweiten Hauptfläche (72) des Leistungshalbleiterbauelements (7) verbunden ist.

3. Schalteinrichtung nach Anspruch 1 oder 2, wobei
das Leistungshalbleiterbauelement (7) mit einer Kontaktfläche (700) seiner ersten Hauptfläche (70) kraft- oder formschlüssig und elektrisch leitend mit der zugeordneten Leiterbahn (22) elektrisch leitend verbunden ist.

4. Schalteinrichtung nach einem der vorhergehenden Ansprüche, wobei
der Druckkörper (50) eine erste Ausnehmung (500) aufweist, aus der das Druckelement (52) hervorsteht.

5. Schalteinrichtung nach Anspruch 4, wobei
die erste Ausnehmung (500) des Druckkörpers (50) als Vertiefung ausgehend von einer ersten Hauptfläche (502) ausgebildet ist, das Druckelement (52) die Ausnehmung (500) des Druckkörpers (50) vollständig oder annährend vollständig ausfüllt und das Druckelement (52) aus der Ausnehmung (500) des Druckkörpers an dessen erster Hauptfläche (502) hervorsteht.

6. Schalteinrichtung nach einem der vorhergehenden Ansprüche, wobei
der Druckkörper (50) aus einem hochtemperaturbeständigen thermoplastischen Kunststoff, insbesondere aus Polyphenylensulfid, und das Druckelement (52) aus einem Elastomer, vorzugsweise einem Silikonelastomer" insbesondere aus einem vernetzten Flüssig-Silikon, besteht.

7. Schalteinrichtung nach einem der vorhergehenden Ansprüche, wobei
die jeweilige stoffschlüssige Verbindung als Löt-, Klebe- oder Drucksinterverbindung ausgebildet ist.

8. Anordnung mit einer elektronischen Schalteinrichtung (1) nach einem der vorhergehenden Ansprüche, mit einer Kühleinrichtung (4) und mit einer Druckeinleiteinrichtung (6), wobei die Druckeinleiteinrichtung (6) sich mittelbar oder unmittelbar gegen die Kühleinrichtung (4) abstützt, vorzugsweise mittig auf die Druckeinrichtung (5) Druck einleitet und hierdurch die Schalteinrichtung (1) kraftschlüssig mit der Kühleinrichtung (4) verbunden ist.

9. Anordnung nach Anspruch 8, wobei
zwischen Substrat (2) und der Kühleinrichtung (4) eine wärmeleitende Schicht (40) mit einer Dicke von weniger als 20µm, insbesondere von weniger als 10µm, insbesondere von weniger als 5µm angeordnet ist.

10. Anordnung nach Anspruch 8, wobei
die Kühleinrichtung (4) eine Grundplatte eines Leistungshalbleitermoduls oder ein Kühlkörper ist.

11. Verfahren zur Herstellung einer ersten Ausgestaltung einer leistungselektronische Schalteinrichtung (1) nach einem der Ansprüche 1 bis 6 mit den Schritten:
A. Bereitstellen des Substrats (2) mit einer Isolationslage (20) und mit gegeneinander elektrisch isolierten Leiterbahnen (22), wobei auf einer der Leiterbahnen (22) ein Leistungshalbleiterbauelement (7) angeordnet und stoffschlüssig mit dieser Leiterbahn (22) verbunden ist;
B. Bereitstellen der Verbindungseinrichtung (3) ausgebildet als Folienstapel alternierend ausgebildet mit zwei elektrisch leitenden, in sich strukturierten Folien (30, 34) und einer elektrisch isolierenden Folie (32) zwischen den beiden leitenden Folien (30,34);
C. Anordnen eines adhäsiven Stoffs (36) auf dem Substrat (2) oder der Verbindungseinrichtung (3) an Klebeabschnitten, die nicht der elektrisch leitenden Verbindung zwischen diesen beiden Verbindungspartnern, also der Verbindungseinrichtung (3) und dem Substrat (2), dienen;
D. Anordnen und haftendes Verbinden der Verbindungseinrichtung (3) mit dem Substrat (2) mittels des adhäsiven Stoffs (36);
E. Druckeinleitung mittels einer Druckeinrichtung (5) und einer Druckeinleiteinrichtung (6) auf die Verbindungseinrichtung (3) derart, dass zwischen der Verbindungseinrichtung (3) und der zugeordneten Leiterbahn (22) eine kraftschlüssige, elektrisch leitende Verbindung ausgebildet wird.

12. Verfahren nach Anspruch 12, wobei
zwischen der Verbindungseinrichtung (3) und dem Leistungshalbleiterbauelement (7) eine kraftschlüssige elektrisch leitende Verbindung ausgebildet wird.

13. Verfahren zur Herstellung einer zweiten Ausgestaltung einer leistungselektronische Schalteinrichtung (1) nach einem der Ansprüche 1 bis 6 mit den Schritten:
a. Bereitstellen des Substrats (2) mit einer Isolationslage (20) und mit gegeneinander elektrisch isolierten Leiterbahnen (22);
b. Bereitstellen der Verbindungseinrichtung (3) ausgebildet als Folienstapel alternierend ausgebildet mit zwei elektrisch leitenden, in sich strukturierten Folien (30, 34) und einer elektrisch isolierenden Folie (32) zwischen den beiden leitenden Folien (30,34);
c. Anordnen des Leistungshalbleiterbauelement (7) auf einer zugeordneten Leiterbahn (22);
d. Anordnen eines adhäsiven Stoffs (36) zu dem Leistungshalbleiterbauelement (7) und zu einer zugeordneten Leiterbahn (22) zur haftenden Fixierung des Leistungshalbleiterbauelements (7) auf dieser Leiterbahn (22);
e. Anordnen und haftendes Verbinden der Verbindungseinrichtung (3) mit dem Substrat (2) mittels des adhäsiven Stoffs (36);
f. Druckeinleitung mittels einer Druckeinrichtung (5) und einer Druckeinleiteinrichtung (6) auf die Verbindungseinrichtung (3) derart, dass zwischen der Verbindungseinrichtung (3) und einer zugeordneten Leiterbahn (22) eine kraftschlüssige, elektrisch leitende Verbindung ausgebildet wird.

14. Verfahren nach Anspruch 13, wobei
sowohl zwischen der Verbindungseinrichtung (3) und dem Leistungshalbleiterbauelement (7), wie auch zwischen dem Leistungshalbleiterbauelement (7) und der zugeordneten Leiterbahn (22) eine kraftschlüssige elektrisch leitende Verbindung ausgebildet wird.
